# EUROPEAN PATENT SPECIFICATION

(11) **EP 4 183 559 B1**
(45) Date of publication and mention of the grant of the patent: **27.08.2025**
(21) Application number: 22206540.1
(22) Date of filing: 10.11.2022
(51) Int. Cl.: B29C 65/08, B65B 51/22, B06B 1/06, H10N 30/80, B29C 65/74, B65B 9/20, H10N 30/50

(54) **SEALING DEVICE FOR A PACKAGING MACHINE, PACKAGING MACHINE HAVING A SEALING DEVICE AND METHOD OF OPERATING A SEALING DEVICE**
SIEGELVORRICHTUNG FÜR EINE VERPACKUNGSMASCHINE, VERPACKUNGSMASCHINE MIT EINER SIEGELVORRICHTUNG UND VERFAHREN ZUM BETREIBEN EINER SIEGELVORRICHTUNG
DISPOSITIF DE SCELLAGE POUR UNE MACHINE DE CONDITIONNEMENT, MACHINE DE CONDITIONNEMENT COMPRENANT UN DISPOSITIF DE SCELLAGE ET PROCÉDÉ DE FONCTIONNEMENT D'UN DISPOSITIF DE SCELLAGE

(30) Priority: 19.11.2021 EP 21209246
(43) Date of publication of application: 24.05.2023
(73) Proprietor: Tetra Laval Holdings & Finance S.A., 1009 Pully (CH)
(72) Inventor: SOCI, Fabio, 41123 Modena (IT); LANCELLOTTI, Mirco, 41123 Modena (IT); CASINI, Giulio, 41123 Modena (IT); PIRROTTA, Onofrio, 41123 Modena (IT)
(74) Representative: Tetra Pak Patent Attorneys

(56) References cited:
- EP-A1- 2 368 694
- EP-A2- 2 990 182
- US-A1- 2014 367 018

## Description

### TECHNICAL FIELD

The present invention relates to a sealing device for the sealing, in particular the transversal sealing, of packages, in particular composite packages, within a packaging machine for the packaging of pourable products, in particular pourable food products.

Advantageously, the present invention also relates to a packaging machine for the packaging of pourable products, in particular pourable food products, into packages, in particular composite packages, and having at least one sealing device for the sealing of packages.

Furthermore, the present invention also relates to a method of operating a sealing device within a packaging machine for the packaging of pourable products, in particular pourable food products, into packages, in particular composite packages.

### BACKGROUND ART

As is known, many liquid or pourable food products, such as fruit juice, UHT (ultra-high-temperature treated) milk, wine, tomato sauce, etc., are sold in packages, in particular sealed packages, made of sterilized packaging material.

A typical example is the parallelepiped-shaped package for pourable food products known as Tetra Brik Aseptic (registered trademark), which is made by sealing and folding a laminated strip packaging material. The packaging material has a multilayer structure comprising a carton and/or paper base layer, covered on both sides with layers of heat-seal plastic material, e.g. polyethylene. In the case of aseptic packages for longstorage products, the packaging material also comprises a layer of oxygen-barrier material, e.g. an aluminum foil, which is superimposed on a layer of heat-seal plastic material, and is in turn covered with another layer of heat-seal plastic material forming the inner face of the package eventually contacting the food product.

Packages of this sort are normally produced on fully automatic packaging machines, which, in use, advance a web of packaging material through a sterilization unit of the packaging machine for sterilizing the web of packaging material. Then, the sterilized web of packaging material is maintained and advanced within an isolation chamber, and is folded and sealed longitudinally to form a tube, which is further advanced. Furthermore, the tube is filled with a pourable product, and is transversally sealed and cut along equally spaced transversal cross sections within a package forming apparatus of the packaging machine during the tube's advancement.

In more detail, the package forming apparatus comprises a plurality of forming and sealing assemblies, each one, in use, shaping and transversally sealing and cutting the tube so as to obtain the single packages.

Each forming and sealing assembly comprises a respective sealing device for transversally sealing the tube for obtaining a respective transversal seal portion by locally compressing the tube and heating the respective portions of the layers of heat-seal plastic material. The heating may e.g. occur by sealing devices generating ultrasonic vibrations. The sealing devices, which heat by means of ultrasound vibrations comprise a sonotrode configured to generate the ultrasonic vibrations and an anvil, which is designed to cooperate with the sonotrode so as to locally compress the tube. Documents EP2990182 A2 and US2014/367018 A1 may be of interest for the present disclosure. EP2368694 A1 discloses a packaging machine for producing sealed packages of pourable food products with sealing means comprising a sonotrode. In EP2368694 A1 plots are made of the module and the phase of the impedance as a function of frequency for the sonotrode.

A typical sonotrode comprises a sonotrode head having a sealing surface extending along a longitudinal axis and a vibration control unit connected to the sonotrode head and configured to actuate ultrasonic vibrations of the sonotrode head. In more detail, the vibration control unit comprises a housing shell and one or more piezoelectric transducers arranged within the housing shell and configured to generate ultrasonic vibrations to be coupled into the sonotrode head.

Even though the known sealing devices operate with a high quality and reliability a desire is felt in the sector to further improve the known sealing devices.

In particular, a desire is felt to control the sealing process as well as possible.

In particular, a desire is felt to operate with the respective sonotrodes as long as possible and to avoid any unwanted failures.

### DISCLOSURE OF INVENTION

It is therefore an object of the present invention to provide in a straightforward and low-cost manner an improved sealing device.

It is a further object of the present invention to provide in a straightforward and low-cost manner a packaging machine having an improved sealing device.

Additionally, it is an object of the present invention to provide in a straightforward and low-cost manner an improved method of operating a sealing device.

According to the present invention, there is provided a sealing apparatus according to the independent claim 1.

Preferred embodiments of the sealing apparatus are claimed in the claims being directly or indirectly dependent on claim 1.

According to the present invention, there is also provided a packaging machine according to claim 8.

Additionally, according to the present invention, there is also provided a method according to claim 9.

A preferred embodiment of the method is claimed in claim 10.

### BRIEF DESCRIPTION OF THE DRAWINGS

A non-limiting embodiment of the present invention will be described by way of example with reference to the accompanying drawings, in which:
Figure 1 is a schematic view of a packaging machine having at least one sealing apparatus according to the present invention, with parts removed for clarity;
Figure 2 is a schematic view of a detail of the packaging machine of Figure 1 comprising portions of the sealing apparatus according to the present invention, with parts removed for clarity;
Figure 3 is a side view of a portion of the sealing apparatus of Figure 2, with parts removed for clarity; and
Figure 4 depicts respective time-dependent curves of electrical parameters as measured with a sensor device of the sealing device and a time-dependent driving signal.

### BEST MODES FOR CARRYING OUT THE INVENTION

Number 1 indicates as a whole a packaging machine for producing packages 2, in particular sealed package 2, of a pourable product, in particular a pourable food product, such as (pasteurized) milk, fruit juice, wine, tomato sauce, salt, sugar etc.

In more detail, packaging machine 1 may be configured to produce packages 2 from a multilayer packaging material.

In further detail, the multilayer packaging material may comprise at least one layer of fibrous material, such as e.g. a paper or cardboard, and at least two layers of heat-seal plastic material, e.g. polyethylene, interposing the layer of fibrous material in between one another. One of these two layers of heat-seal plastic material defining the inner face of package 2 contacting the pourable product.

Moreover, the packaging material may also comprise a layer of gas- and light-barrier material, e.g. aluminum foil or ethylene vinyl alcohol (EVOH) film, in particular being arranged between one of the layers of the heat-seal plastic material and the layer of fibrous material. Preferentially, the packaging material may also comprise a further layer of heat-seal plastic material being interposed between the layer of gas- and light-barrier material and the layer of fibrous material.

In further detail, the multilayer packaging material may be provided in the form of a web 3. In particular, web 3 may comprise a plurality of repeated patterns, each pattern defining a respective blank for the formation of one respective package 2.

Furthermore, packaging machine 1 may be configured to produce packages 2 by forming a tube 4 from web 3, longitudinally sealing tube 4, filling tube 4 with the pourable product and to transversally seal and cut tube 4.

A typical package 2 obtained by packaging machine 1 comprises a longitudinal seam portion 5 and a pair of a respective first transversal sealing band and a respective second transversal sealing band, in particular arranged at opposite sides of package 2. In particular, the first transversal sealing band may define a transversal top sealing band and the second transversal sealing band may define a transversal bottom sealing band.

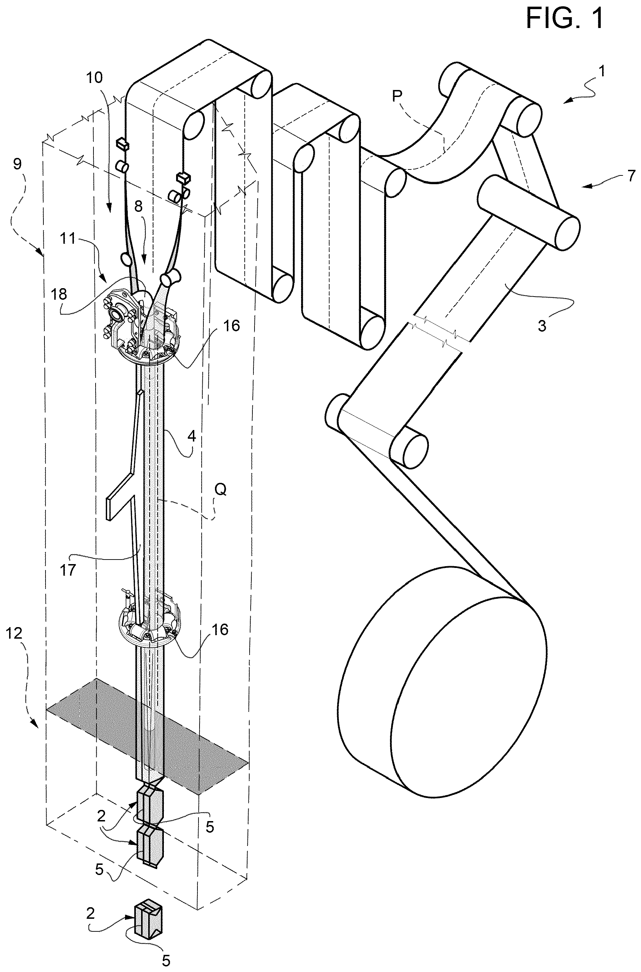

With particular reference to Figure 1, packaging machine 1 may comprise:
- a conveying device 7 for advancing (in a known manner) web 3 along a web advancement path P to a forming station 8, at which, in use, web 3 is formed into tube 4;
- an isolation chamber 9 having an inner environment, in particular an inner sterile environment containing a sterile gas, and being separated from an (hostile) outer environment;
- a tube forming and sealing device 10 configured to form tube 4 from the, in use, advancing web 3 within the inner environment and to longitudinally seal tube 4 within the inner environment;
- a filling device 11 for continuously filling tube 4 with the pourable product; and
- a package forming apparatus 12 configured to form, to transversally seal and to transversally cut the, in use, advancing tube 4 for forming packages 2.

Moreover, packaging machine 1 may also comprise a sterilizing unit configured to sterilize the, in use, advancing web 3 at a sterilization station, in particular the sterilization station being arranged upstream of forming station 8 along web advancement path P.

In more detail, conveying device 7 may be configured to advance tube 4 and any intermediates of tube 4 along a tube advancement path Q, in particular from forming station 9 to package forming unit 16. In particular, under intermediates of tube 4 any configuration of web 3 is meant prior to obtaining the tube structure and after folding of web 3 by tube forming and sealing device 10 has started. In other words, the intermediates of tube 4 are a result of the gradual folding of web 3 so as to obtain tube 4, in particular by overlapping the edges of web 3 with one another.

Preferably, tube forming and sealing device 10 may be arranged such that tube 4 may present a vertical orientation.

In more detail, tube forming and sealing device 10 may comprise at least two forming ring assemblies 16, in particular arranged within isolation chamber 9, being configured to gradually fold in cooperation with one another web 3 into tube 4, in particular by overlapping the edges of web 3 with one another. Thereby, in use, seam portion 5 of tube 3 is formed.

Additionally, tube forming and sealing device 10 may comprise a sealing head 17, in particular arranged within isolation chamber 9 and, configured to longitudinally seal tube 4, in particular along seam portion 5.

Moreover, tube forming and sealing device 10 may also comprise a pressuring assembly configured to exert a mechanical force on seam portion 5 so as to ensure sealing of tube 4 along seam portion 5.

Additionally, filling device 11 may comprise a filling pipe 18 being configured to direct, in use, the pourable product into tube 4. In particular, filling pipe 18 may, in use, be at least partially placed within tube 4 for feeding, in use, the pourable product into tube 4.

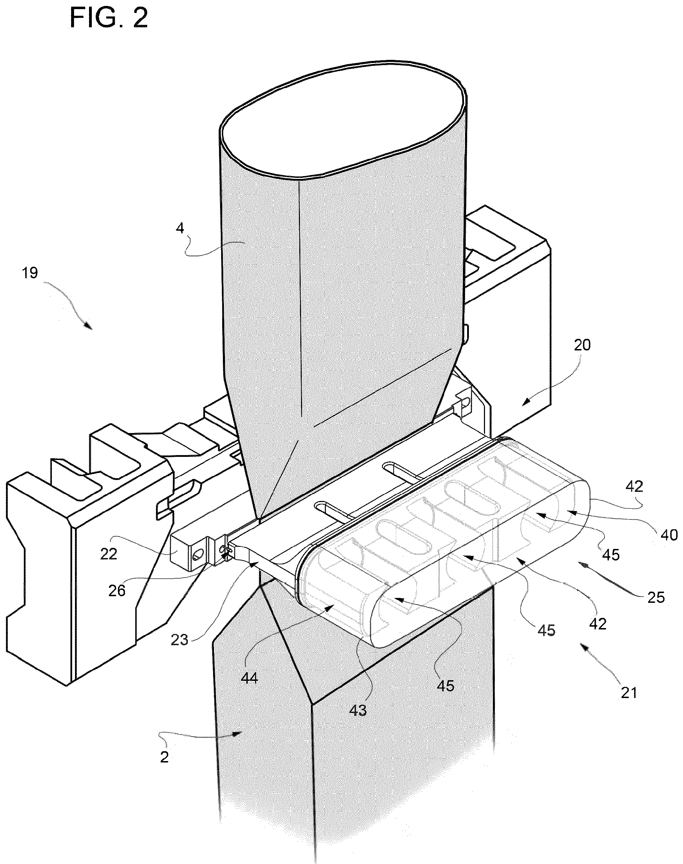

With particular reference to Figures 1 and 2, package forming apparatus 12 may comprise:
- a plurality of forming and sealing assemblies 19 (only partially shown to the extent necessary for the comprehension of the present invention in Figure 2), each one configured to at least form (shape) tube 4, to transversally seal tube 4, and in particular to also transversally cut tube 4; and
- a conveying unit (not shown and known as such) so as to advance forming and sealing assemblies 19.

In particular, package forming apparatus 12 may be configured to control forming and sealing assemblies 19 and the conveying unit such to transversally seal and cut tube 4 along equally spaced transversal cross sections. Even more particularly, package forming apparatus 12 may be configured to control forming and sealing assemblies 19 and the conveying unit such to transversally seal and cut tube 4 also in dependence of the repeated patterns.

In more detail, each forming and sealing assembly 19 may comprise:
- a forming shell (not shown and known as such) configured to at least partially define the shape of packages 2; and
- a sealing apparatus 20 configured to at least transversally compress, in particular flat-lay and squeeze, and to transversally seal tube 4, in particular during advancement of tube along path Q and between two respective packages 2.

Moreover, each forming and sealing assembly 19 may comprise a cutting device (not shown) for transversally cutting tube 4.

Preferentially, each sealing apparatus 20 may be configured to form a main sealing band, and in particular the respective cutting device may be configured to transversally cut through the main sealing band. Even more preferentially, each main sealing band combines the respective first transversal sealing band of a leading package 2 and the respective second transversal sealing band of the successive package 2.

In further detail, each forming shell may comprise at least a first half-shell (not shown and known as such) and a second half-shell (not shown and known as such) configured to at least partially define in cooperation the shape of packages 2. In particular, the first half-shell and the second half-shell may be configured to contact tube 4 from opposite sides thereof.

In more detail, each sealing apparatus 20 may be of the ultrasonic type; i.e. sealing apparatus 20 may be configured to generate ultrasonic vibrations suited to heat portions of the layers of heat-seal plastic material.

Moreover, each sealing apparatus 20 comprises at least:
- a sonotrode 21 for generating ultrasonic vibrations, in particular for heating/melting the respective portions of the layers of heat-seal plastic material; and
- an anvil 22 for compressing, in particular for locally flat-lying and squeezing tube 4, in cooperation with sonotrode 21.

In further detail, each cutting device may comprise at least one moveable blade so as to transversally cut tube 4.

Furthermore, each sonotrode 21 may be associated to one respective first half-shell, in particular defining a first operative portion of the respective forming and sealing assembly 19, and each anvil 22 may be associated to one respective second half-shell, in particular defining a second operative portion of the respective forming and sealing assembly 19.

Additionally, the respective blade of the respective cutting device may be associated to the respective sonotrode 21 or to the respective anvil 22, in the specific case the respective anvil 22. In other words, each cutting device may either be associated to the respective first operative portion or the respective second operative portion, in the specific case shown to the respective second operative portion.

Furthermore, the conveying unit may be configured to advance the respective first operative portions along a first path and the respective second operative portions along a second path.

Moreover, each first operative portion and the respective second operative portion may be configured to cooperate with one another for forming a package 2 when advancing along a respective operative section of the first path and the second path, respectively.

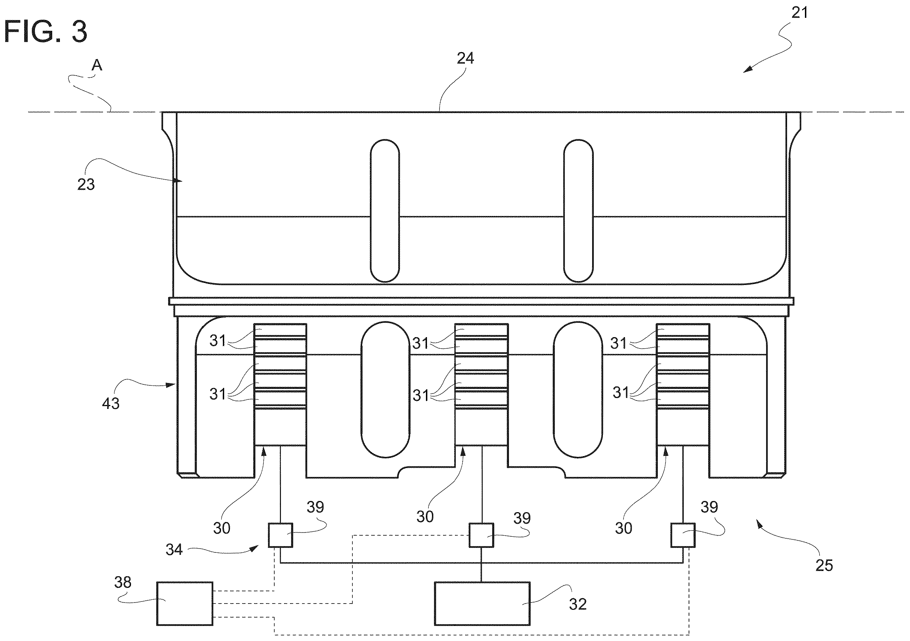

With particular reference to Figures 2 and 3, each sonotrode 21 comprises at least:
- a sonotrode head 23, in particular having a sealing surface 24 extending along a longitudinal axis A; and
- a vibration control unit 25 connected to sonotrode head 23 and configured to actuate ultrasonic vibrations of sonotrode head 23.

In more detail, each sealing surface 24 may be designed to contact tube 4 and to establish an operative connection with the portions of the layers of heat-seal plastic material.

Furthermore, each sealing surface 24 may comprise a first portion and a second portion displaced from and being parallel to one another.

Moreover, each sonotrode head 23 may comprise a groove 26, in particular interposed between the respective first portion and the respective second portion. In particular, each groove 26 may be designed to receive a portion of the respective blade during the transversal cutting of tube 4.

Reverting to Figure 3, each vibration control unit 25 may comprise one or more piezoelectric transducer devices 30 configured to generate the ultrasonic vibrations to be coupled into the respective sonotrode head 23. In the specific case shown, vibration control unit 25 may comprise three piezoelectric transducer devices 30, however, the number may vary in dependence of the format of packages 2 and/or in dependence of dimensions of the sealing surface; i.e. in dependence of the format of packages 2, the extension of sealing surface 24 may be larger or shorter; in particular a shorter sealing surface 24 may require less piezoelectric transducer devices 30 than a larger one.

With particular reference to Figure 3, each piezoelectric transducer device 30 may comprise a plurality of piezoelectric (ceramic) elements 31 stacked one on top of one another. In more detail, each piezoelectric transducer device 30 may also comprise a plurality of conductive metal sheets, in particular forming together with piezoelectric elements 31 a stack of alternate piezoelectric elements 31 and conductive metal sheets.

Additionally, each sealing apparatus 20, in particular the respective vibration control unit 25, may comprise one or more generators 32 operatively connected to piezoelectric transducer(s) 30, in particular piezoelectric elements 31, so as to actuate and control the ultrasonic vibrations of piezoelectric transducer(s) 30.

In particular, each generator 32 may be configured to introduce a driving signal into the respective piezoelectric transducers 30, in particular into the respective stack of piezoelectric elements 31.

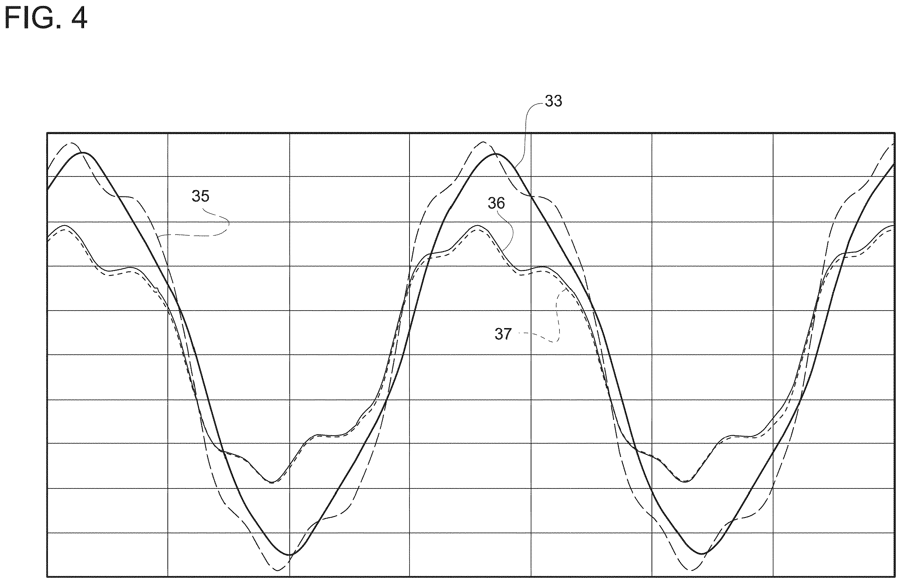

In more detail and with particular reference to Figure 4, such a driving signal may be an AC voltage signal 33 (see e.g. Figure 4). In particular, according to such an example piezoelectric transducers 30 may be arranged electrically in parallel.

Alternatively, piezoelectric transducers 30 may be arranged electrically in series and the driving signal may be an AC current signal.

Advantageously, each sealing apparatus 20 comprises a sensor device 34 configured to measure, in use, one or more time-dependent electrical parameters or electrical quantities of at least one, e.g. of each one, of the one or more piezoelectric transducer devices 30, in particular of the respective stack of piezoelectric elements 31. For example, the electrical parameters or electrical quantities may be measured at the respective piezoelectric transducers 30, after the driving signal subdivides for each different piezoelectric transducer 30. The measurement may occur for one or more or all the piezoelectric transducers 30.

In particular, each sensor device 34 is configured to obtain real-time measurements of the one or more time-dependent electrical parameters.

Example time-dependent electrical parameters or quantities may comprise the electrical current, the electrical voltage and/or the electrical power.

In more detail, each sensor device 34 may be configured to determine the time-dependent electrical parameters of each one of the one or more piezoelectric transducer device 30, in particular of the respective stack of piezoelectric elements 31, independently and selectively from the other piezoelectric transducer devices 30, in particular of the other respective stacks of piezoelectric elements 31.

Preferentially, each sensor device 34 may be configured to determine respective time-dependent curves of the one or more electrical parameters of each one of the one or more piezoelectric transducer devices 30, in particular of the respective stacks of piezoelectric elements 31.

In the specific case shown and with particular reference to Figure 4, each sensor device 34 is configured to determine a first time-dependent curve 35 associated to a first one of the three piezoelectric transducer devices 30, a second time-dependent curve 36 associated to a second one of the three piezoelectric transducer devices 30 and a third time-dependent curve 37 associated to a third one of the three piezoelectric transducer devices 30.

Moreover first time-dependent curve 35, second time-dependent curve 36 and third time-dependent curve 37 may be indicative of the electrical parameters or quantities, e.g. , according to the specific example shown, the first, second and third time-dependent curves 35, 36, 37 depict the respective time-dependent electrical currents flowing through the respective piezoelectric transducer devices 30, in particular of the respective stacks of piezoelectric elements 31.

Alternatively, in a similar manner, also other electrical parameters may be determined and their time-dependent curves may be measured.

According to some non-limiting embodiments, each sensor device 34 may be configured to measure the respective time-dependent curves for more than one electrical parameter of each piezoelectric transducer device 30, in particular of the respective stacks of piezoelectric elements 31.

Preferentially, each sealing apparatus 20, in particular the respective sensor device 34, may comprise a memory configured to store, in particular at least temporarily store, the electrical parameters and/or the respective time-dependent curves.

In further detail, each sealing apparatus 20 may comprise an analyzing unit 38 operatively connected, e.g. directly or indirectly, e.g. wirelessly, to the respective sensor device 34 and configured to receive and analyze the time-dependent electrical parameters, in particular the respective time-dependent curves.

More specifically, each analyzing unit 38 may be configured to:
- determine characteristic parameters or features from the one or more time-dependent curves; and/or
- to deduce characteristic parameters or features from the one or more time-dependent curves and to compare the characteristic parameters or features with reference parameters or features; and/or
- to compare one or more of the time-dependent curves with reference curves; and/or
- to analyze respective shapes of the time-dependent curves.

The characteristic parameters or features may comprise root-mean-square values, frequencies, powers, instantaneous powers, phase shifts between current and voltage and/or dissipated powers of the one or more time-dependent curves.

In one or more embodiments, the sonotrode may be represented by an (equivalent) electrical circuit comprising a capacitance of the stacks of piezoelectric elements 31, an equivalent resistance, an equivalent inductance and an equivalent capacitance. In other words, a sonotrode circuit may be approximated using the above-mentioned equivalent electrical circuit. The analyzing unit 38 may be configured to calculate, as a function of the characteristic parameters or features of the time-dependent curves, the capacitance of the stacks of piezoelectric elements 31, the equivalent resistance, the equivalent inductance and the equivalent capacitance.

Alternatively or additionally, each analyzing unit 38 may be configured to determine information, e.g. quality information, about the transversal sealing process of the respective sealing apparatus 20 from the determined electrical parameters, in particular the respective time-dependent curves. E.g. each analyzing unit 38 may use such information for evaluating the quality of the respective transversal sealing process and/or to determine pressures acting on varying portions of the respective main sealing band.

According to some non-limiting embodiments, each analyzing unit 38 may be configured to selectively determine respective operating states of the one or more piezoelectric transducer devices 30, in particular of the respective stacks of piezoelectric elements 31, in dependence of the respective electrical parameters, in particular of the respective time-dependent curves, determined by the respective sensor device 34.

Preferentially, each sealing apparatus 20 may also comprise a temperature sensing device configured to determine a temperature, in particular a time-dependent temperature-profile, of the respective one or more piezoelectric transducer devices 30, in particular of the respective stacks of piezoelectric elements 31.

Advantageously, each analyzing unit 38 may be configured to selectively determine the operating state of the respective one or more piezoelectric transducer devices 30 in dependence of the respective electrical parameters, in particular the respective time-dependent curves, determined by the respective sensor device 34 and the respective temperature, in particular the respective time-dependent temperature profile, as determined by the respective temperature sensing device.

Preferentially, the operating state of each piezoelectric transducer device 30, in particular the respective stack of piezoelectric elements 31, may contain information about the aging and/or health and/or the remaining life-time of the respective piezoelectric transducer device 30, in particular the respective stack of piezoelectric elements 31.

According to some non-limiting embodiments, each analysis unit 38 and/or a processing unit of sealing apparatus 20 and/or packaging machine 1 may be configured to plan maintenance activities based on the respective operating states of piezoelectric transducer devices 30. In particular, analysis unit 38 and/or the processing unit may be configured to plan the maintenance activities as a function of the remaining life-time and/or the aging and/or the health of piezoelectric transducer devices 30. In this way, it is possible to optimize the use of piezoelectric transducer devices 30.

Preferentially, each analysis unit 38 and/or the processing unit may be configured to (directly or indirectly) signal the remaining lifetime of a piezoelectric transducer device 30 and signal that the maintenance should be executed within a certain time regime.

Alternatively or in addition, each analysis unit 38 and/or the processing unit may be configured to assess the possible occurrence of an anomalous working condition of the one or more piezoelectric transducer devices 30 in dependence of the respective electrical parameters, in particular the respective time-dependent curves. Moreover, each analysis unit 38 and/or the processing unit may be configured to alert about the risk of an anomalous working condition, e.g. by means of a prompt on a human-machine interface (of packaging machine 1) and/or an acoustic message and/or an electronic message or similar.

With particular reference to Figure 3, each sensor device 34 may comprise one or more sensor elements 39, each one associated to one respective piezoelectric transducer device 30, in particular the respective stack of piezoelectric elements, for measuring the one or more time-dependent electrical parameters of the respective piezoelectric transducer device 30. For example, each sensor device 34 may comprise a plurality of sensor elements 39, that may be associated with a respective plurality of stacks of piezoelectric elements.

Preferentially, each sensor element 39 may comprise at least one Hall effect sensor and/or at least one Shunt sensor.

According to some non-limiting embodiments, sensor device 34 may comprise a one or more measurement circuits, in particular comprising portions for signal amplification and/or signal filtration.

The one or more measurement circuits may comprise or may be connected to sensor elements 39.

According to some preferred non-limiting embodiments, each sensor device 34 may comprise a board carrying the respective sensor elements 39, and in particular also the respective measurement circuits.

According to some non-limiting embodiments, each analysis unit 38 may be arranged on the respective board of the respective sensor device 34.

Alternatively or in addition, each sensor device 34 may comprise a communication group operatively coupled to the respective analysis unit 38 for transferring the respective electrical parameters, in particular the time-dependent curves.

Moreover, each communication group may be configured to communicate with the respective analysis unit 38 by means of wiring and/or wirelessly.

According to some possible embodiments, each analysis unit 38 may be spaced apart from the respective sensor device 34 and/or may be part of and/or may be incorporated into a central analysis unit of package forming apparatus 12 and/or of packaging machine 1.

With particular reference to Figures 2 and 3, vibration control unit 25 may further comprise at least a housing shell 41 having an inner space 41.

Additionally, each vibration control unit 25 may further comprise at least a housing shell 41 (shown in Figure 2; the transparent representation is for illustrative reasons) having an inner space 41. In particular, housing shell 41 is in contact with the respective sonotrode head 23 so as to seal inner space 41 from an outer space.

Preferentially, each piezoelectric transducer device 30 and each sensor device 34 may be arranged within the respective inner space 41; i.e. being enclosed by the respective housing 40. In particular, the respective boards of each sensor device 34 may be arranged within the respective inner space 41. Such solutions allow a compact construction.

In particular, also the respective generator(s) 32 may be arranged within the respective inner space 41.

In more detail, each housing 40 may comprise a main wall 42, a lateral wall 43 extending from main wall 42 and an opening opposite to main wall 42.

Moreover, each vibration control unit 25 may comprise a coupling portion 44 contacting the respective sonotrode head 23 along a respective contact surface. Additionally, each piezoelectric transducer device 30 may be placed within a respective seat 45 (see in particular Figure 2) of the respective coupling portion 44 and in contact with coupling portion 44 so as to allow for the transmission of the generated ultrasonic vibrations into the respective sonotrode head 23.

In particular, the respective opening of each housing 40 may be designed to allow for introducing the respective coupling portion 44 into inner space 41.

Moreover, each sensor device 34 may be arranged within a portion of the respective inner space 41 being interposed between the respective coupling portion 44 and a main wall 42. E.g. each board may be mounted to the respective main wall 42.

In use, packaging machine 1 produces packages 2 filled with the pourable product.

In more detail, conveying device 7 advances web 3 along web advancement path P to forming station 8. Tube forming and sealing device 10 forms tube 4 from the advancing web 3 and longitudinal seals tube 4. Additionally, filling device 11 fills tube 4 with the pourable product and package forming unit 12 forms, transversally seals and transversally cuts tube 4 so as to obtain packages 2.

In further detail, during operation of package forming unit 12, forming and sealing assemblies 19 form, transversally seal, and in particular also transversally cut tube 4 for obtaining respective filled packages 2.

Thereby, the forming occurs by means of the respective forming shell, in particular the cooperation of the respective first half-shell and the second half-shell with one another.

Additionally, the transversal sealing occurs by means of the respective sealing apparatus 20.

Moreover, the transversal cutting occurs by means of the respective cutting device.

In more detail, operation of each sealing apparatus 20 comprises at least the following main steps:
- compressing, in particular flat-lying and squeezing, tube 4 by cooperation of the respective anvil 22 and the respective sonotrode 21; and
- generating ultrasonic vibrations by means of sonotrode 21 for heating portions of the layers of heat-seal plastic material.

In even more detail, operation of each sealing apparatus 20 further comprises the steps of:
a) exciting ultrasonic vibrations of the respective sonotrode head 23 by means of operation of vibration control unit 25, in particular the respective generator(s) 32, the respective piezoelectric transducer(s) 30; and
b) measuring one or more time-dependent electrical parameters of at least one of, e.g. each one of, the one or more piezoelectric transducer devices 30, in particular of the respective stacks of piezoelectric elements 31.

In more detail, during each step b), the respective sealing device 34 may measure the respective time-dependent electrical parameters, in particular the respective time-dependent curves.

Preferentially, operation of each sealing apparatus 20 may also comprise a step c) measuring, in particular by means of the respective temperature sensing, the temperature of the one or more respective piezoelectric transducers 30.

According to preferred non-limiting embodiments, operation of each sealing apparatus 20 may also comprise a step d) of analyzing, in particular by means of the respective analyzing unit 38, the electrical parameters, in particular the time-dependent curves.

In particular, during step d) each analyzing unit 38 may:
- determine one or more characteristic parameters from the one or more time-dependent curves; and/or
- deduce one or more characteristic parameters from the one or more time-dependent curves and to compare the characteristic parameters with reference parameters; and/or
- calculate, as a function of one or more characteristic parameters of the time-dependent curves, a capacitance of the stacks of piezoelectric elements 31, an equivalent resistance, an equivalent inductance and an equivalent capacitance of an (equivalent) electrical circuit representing the sonotrode (electrical circuit); and/or
- compare one or more of the time-dependent curves with reference curves; and/or
- analyze respective shapes of the time-dependent curves; and/or
- determine information, e.g. quality information, about the transversal sealing process of the respective sealing apparatus 20; and/or
- determine an operating state of the one or more piezoelectric transducer devices 30.

In addition or alternatively, during the step d) the remaining life time and/or the aging and/or the health and/or an anomalous working condition of the one or more piezoelectric transducer devices 30 may determined.

According to some possible non-limiting embodiments, during step d) also the temperature of the one or more piezoelectric transducer devices 30 may be considered.

Furthermore, operation of each sealing apparatus 20 may further comprise a step of transferring, during which the measurement results from step b), in particular also from step c) may be transferred to analysis unit 38 and/or the processing unit.

Additionally, operation of each sealing apparatus 20 may further comprise a step of planning, during which a maintenance is planned based on the operating state of the one or more piezoelectric transducer(s) 30. In particular, in this way, the maintenance can be planned based on the effective remaining life-time and/or aging and/or health of the respective one or more piezoelectric transducer(s) 30.

Moreover, operation of each sealing apparatus 20 may also comprise a step of alerting, during which the risk of an anomalous working condition may be signaled, e.g. by means of a prompt on a human-machine interface and/or an acoustic message and/or an electronic message of similar.

The advantages of sealing apparatus 20 and/or of packaging machine 1 and/or the method according to the present invention will be clear from the foregoing description.

In particular, by each sealing apparatus 20 having sensor device 34 it is possible to monitor in real-time the respective sonotrode 21 by monitoring electrical parameters of piezoelectric transducer devices 30.

A further advantage resides in that it is possible to obtain a direct feedback from piezoelectric transducer devices 30 so as to monitor the sealing process.

Another advantage is seen in that sensor device 34 can be economically realized.

An even other advantage resides in that sensor device 34 enables conditioning monitoring and predictive maintenance.

Moreover, an advantage is also that the data from sensor device 34 allows process control.

Clearly, changes may be made to sealing devices 20 and/or packaging machine 1 and/or the method as described herein without, however, departing from the scope of protection as defined in the accompanying claims.

## Claims

1. Sealing apparatus (20) for sealing packages (2) filled with a pourable product within a packaging machine (1) ;
the sealing apparatus (20) having at least one sonotrode (21) comprising at least:
- a sonotrode head (23); and
- a vibration control unit (25) connected to the sonotrode head (23) and configured to actuate ultrasonic vibrations of the sonotrode head (23);
wherein the vibration control unit (25) comprises:
- one or more piezoelectric transducer devices (30) configured to generate ultrasonic vibrations to be coupled into the sonotrode head (23); and
- a sensor device (34) configured to measure, in use, one or more time-dependent electrical parameters of at least one of the one or more piezoelectric transducer devices (30),wherein the sensor device (34) is configured to determine respective time-dependent curves (33, 35, 36, 37) of the one or more electrical parameters of the one or more piezoelectric transducer devices (30),
wherein the sealing apparatus further comprises an analyzing unit (38) operatively connected to the sensor device (34) and configured to receive and analyze the time-dependent curves, wherein the analyzing unit (38) is configured to:
- determine one or more characteristic parameters from the one or more time-dependent curves (33, 35, 36, 37) ; and/or
- determine one or more characteristic parameters from the one or more time-dependent curves (33, 35, 36, 37) and compare the determined characteristic parameters with reference parameters; and/or
- calculate, as a function of one or more characteristic parameters of the time-dependent curves (33, 35, 36, 37), a capacitance of the stacks of piezoelectric elements (31), an equivalent resistance, an equivalent inductance and an equivalent capacitance of an electrical circuit representing the sonotrode; and/or
- compare one or more of the time-dependent curves (33, 35, 36, 37) with reference curves; and/or
- analyze respective shapes of the time-dependent curves (33, 35, 36, 37); and/or
- determine information about the sealing process from the time-dependent curves (33, 35, 36, 37).

2. Sealing apparatus according to claim 1, wherein the electrical parameters are chosen from the group of: electrical current, electrical voltage, and/or electrical power.

3. Sealing apparatus according to any one of the preceding claims, further comprising an analyzing unit (38) operatively connected to the sensor device (34) and configured to selectively determine an operating state of the one or more piezoelectric transducer devices (30) in dependence of the respective electrical parameters determined by the sensor device (34).

4. Sealing apparatus according to any of the previous claims, comprising a temperature sensing device configured to determine a temperature of the one or more piezoelectric transducer devices (30).

5. Sealing apparatus according to claim 4, further comprising an analyzing unit (38) operatively connected to the sensor device (34) and configured to selectively determine an operating state of the one or more piezoelectric transducer devices (30) in dependence of the respective electrical parameters determined by the sensor device (34) and the temperature determined by the temperature sensing device.

6. Sealing apparatus according to any one of the preceding claims, wherein the vibration control unit (25) further comprises at least a housing shell (41) having an inner space (41);
wherein each piezoelectric transducer device (30) and the sensor device (34) are arranged within the housing shell (41).

7. Sealing apparatus according to any of the preceding claims, wherein the sensor device (34) comprises one or more sensor elements (39) each one associated to one respective piezoelectric transducer device (30) for measuring the one or more time-dependent electrical parameters of the respective piezoelectric transducer device (30), wherein the one or more sensor elements (39) preferably comprise one or more Hall effect sensors and/or Shunt sensors.

8. Packaging machine (1) for the packaging of pourable products into packages (2) comprising at least one sealing apparatus (20) according to any one of claims 1 to 7.

9. Method of operating a sealing apparatus (20) according to any one of claims 1 to 7, the method comprising at least the steps of:
a) exciting ultrasonic vibrations of the sonotrode head (23) by means of operation of the one or more piezoelectric transducer devices (30);
b) measuring one or more time-dependent electrical parameters of at least one, preferably each one, of the one or more piezoelectric transducer devices (30),
d) analyzing the electrical parameters, wherein during the step d), an analyzing unit (38) of the sealing apparatus (20):
- determines one or more characteristic parameters from one or more time-dependent curves of the electrical parameters; and/or
- deduces one or more characteristic parameters from the one or more time-dependent curves and compares the characteristic parameters with reference parameters; and/or
- calculates, as a function of one or more characteristic parameters of the time-dependent curves, a capacitance of the stacks of piezoelectric elements (31), an equivalent resistance, an equivalent inductance and an equivalent capacitance of an electrical circuit representing the sonotrode; and/or
- compares one or more of the time-dependent curves with reference curves; and/or
- analyzes respective shapes of the time-dependent curves; and/or
- determines information, preferably quality information, about the sealing process executed by the sealing apparatus (20) based on the one or more time-dependent electrical parameters; and/or
- determines an operating state of the one or more piezoelectric transducer devices based on the one or more time-dependent electrical parameters.

10. Method according to claim 9, wherein during the step d) the remaining life time and/or the aging and/or the health and/or an anomalous working condition of the one or more piezoelectric transducer devices (30) is determined.

## Patentansprüche

1. Siegelvorrichtung (20) zum Versiegeln von Verpackungen (2), die mit einem gießbarem Produkt gefüllt werden, innerhalb einer Verpackungsmaschine (1);
wobei die Siegelvorrichtung (20) wenigstens eine Sonotrode (21) aufweist, die wenigstens Folgendes umfasst:
- einen Sonotrodenkopf (23); und
- eine Vibrationssteuereinheit (25), die mit dem Sonotrodenkopf (23) verbunden und zum Auslösen von Ultraschallvibrationen des Sonotrodenkopfes (23) konfiguriert ist;
wobei die Vibrationssteuereinheit (25) Folgendes umfasst:
- eine oder mehrere piezoelektrische Wandlervorrichtungen (30), die zum Erzeugen von Ultraschallvibrationen konfiguriert sind, die in den Sonotrodenkopf (23) einzukoppeln sind; und
- eine Sensorvorrichtung (34), die zum Messen, im Betrieb, von einem oder mehreren zeitabhängigen elektrischen Parametern von wenigstens einer der einen oder mehreren piezoelektrischen Wandlervorrichtungen (30) konfiguriert ist, wobei die Sensorvorrichtung (34) zum Bestimmen jeweiliger zeitabhängiger Kurven (33, 35, 36, 37) des einen oder der mehreren elektrischen Parameter der einen oder mehreren piezoelektrischen Wandlervorrichtungen (30) konfiguriert ist,
wobei die Siegelvorrichtung ferner eine Analyseeinheit (38) umfasst, die operativ mit der Sensorvorrichtung (34) verbunden und zum Empfangen und Analysieren der zeitabhängigen Kurven konfiguriert ist, wobei die Analyseeinheit (38) zu Folgendem konfiguriert ist:
- einen oder mehrere charakteristische Parameter aus den zeitabhängigen Kurven (33, 35, 36, 37) zu bestimmen; und/oder
- einen oder mehrere charakteristische Parameter aus den zeitabhängigen Kurven (33, 35, 36, 37) zu bestimmen und die bestimmten charakteristischen Parameter mit Referenzparametern zu vergleichen; und/oder
- als eine Funktion von einem oder mehreren charakteristischen Parametern der zeitabhängigen Kurven (33, 35, 36, 37) eine Kapazität der Stapel piezoelektrischer Elemente (31), den äquivalenten Widerstand, die äquivalente Induktivität und die äquivalente Kapazität eines die Sonotrode darstellenden Stromkreises zu berechnen; und/oder
- eine oder mehrere der zeitabhängigen Kurven (33, 35, 36, 37) mit Referenzkurven zu vergleichen; und/oder
- die jeweiligen Formen der zeitabhängigen Kurven (33, 35, 36, 37) zu analysieren; und/oder
- Informationen über den Versiegelungsprozess aus den zeitabhängigen Kurven (33, 35, 36, 37) zu bestimmen.

2. Siegelvorrichtung nach Anspruch 1, wobei die elektrischen Parameter aus der folgenden Gruppe ausgewählt sind: elektrischer Strom, elektrische Spannung und/oder elektrische Leistung.

3. Siegelvorrichtung nach einem der vorhergehenden Ansprüche, ferner umfassend eine Analyseeinheit (38), die operativ mit der Sensorvorrichtung (34) verbunden ist und zum selektiven Bestimmen des Betriebszustands der einen oder mehreren piezoelektrischen Wandlervorrichtungen (30) in Abhängigkeit der von der Sensorvorrichtung (34) bestimmten elektrischen Parameter konfiguriert ist.

4. Siegelvorrichtung nach einem der vorhergehenden Ansprüche, umfassend eine Temperaturmessvorrichtung, die zum Bestimmen der Temperatur der einen oder mehreren piezoelektrischen Wandlervorrichtungen (30) konfiguriert ist.

5. Siegelvorrichtung nach Anspruch 4, ferner umfassend eine Analyseeinheit (38), die operativ mit der Sensorvorrichtung (34) verbunden ist und zum selektiven Bestimmen des Betriebszustands der einen oder mehreren piezoelektrischen Wandlervorrichtungen (30) in Abhängigkeit der von der Sensorvorrichtung (34) bestimmten elektrischen Parameter und der von der Temperaturmessvorrichtung bestimmten Temperatur konfiguriert ist.

6. Siegelvorrichtung nach einem der vorhergehenden Ansprüche, wobei die Vibrationssteuereinheit (25) ferner wenigstens eine Gehäusehülle (41) mit einem Innenraum (41) umfasst;
wobei jede piezoelektrische Wandlervorrichtung (30) und die Sensorvorrichtung (34) innerhalb des Innenraums (41) angeordnet sind.

7. Siegelvorrichtung nach einem der vorhergehenden Ansprüche, wobei die Sensorvorrichtung (34) ein oder mehrere Sensorelemente (39) umfasst, die jeweils einer jeweiligen piezoelektrischen Wandlervorrichtung (30) zugeordnet sind, um den einen oder die mehreren zeitabhängigen elektrischen Parameter der jeweiligen piezoelektrischen Wandlervorrichtung (30) zu messen, wobei das eine oder die mehreren Sensorelemente (39) vorzugsweise einen oder mehrere Hall-Effekt-Sensoren und/oder Shunt-Sensoren umfassen.

8. Verpackungsmaschine (1) für das Verpacken von gießbaren Produkten in Verpackungen (2), welche wenigstens eine Siegelvorrichtung (20) nach einem der Ansprüche 1 bis 7 umfasst.

9. Verfahren zum Betreiben einer Siegelvorrichtung (20) nach einem der Ansprüche 1 bis 7, wobei das Verfahren wenigstens die folgenden Schritte umfasst:
a) Anregen von Ultraschallvibrationen des Sonotrodenkopfes (23) mittels eines Betriebs der einen oder mehreren piezoelektrischen Wandlervorrichtungen (30);
b) Messen des einen oder der mehreren zeitabhängigen elektrischen Parameter der jeweiligen wenigstens einen, vorzugsweise jeder, der piezoelektrischen Wandlervorrichtungen (30),
d) Analysieren der elektrischen Parameter, wobei während des Schrittes d) eine Analyseeinheit (38) der Siegelvorrichtung (20):
- einen oder mehrere charakteristische Parameter aus den zeitabhängigen Kurven der elektrischen Parameter bestimmt; und/oder
- einen oder mehrere charakteristische Parameter aus den zeitabhängigen Kurven ableitet und die bestimmten charakteristischen Parameter mit Referenzparametern vergleicht; und/oder
- als eine Funktion von einem oder mehreren charakteristischen Parametern der zeitabhängigen Kurven eine Kapazität der Stapel piezoelektrischer Elemente (31), einen äquivalenten Widerstand, eine äquivalente Induktivität und eine äquivalente Kapazität eines die Sonotrode darstellenden Stromkreises berechnet; und/oder
- eine oder mehrere der zeitabhängigen Kurven mit Referenzkurven vergleicht; und/oder
- jeweilige Formen der zeitabhängigen Kurven analysiert; und/oder
- Informationen, vorzugsweise Qualitätsinformationen, über den von der Siegelvorrichtung (20) ausgeführten Versiegelungsprozess basierend auf dem einen oder den mehreren zeitabhängigen elektrischen Parametern bestimmt; und/oder
- einen Betriebszustand der einen oder mehreren piezoelektrischen Wandlervorrichtungen basierend auf dem einen oder den mehreren zeitabhängigen elektrischen Parametern bestimmt.

10. Verfahren nach Anspruch 9, wobei während des Schrittes d) die verbleibende Lebensdauer und/oder die Alterung und/oder der Funktionszustand und/oder ein anomaler Betriebszustand der einen oder der mehreren piezoelektrischen Wandlervorrichtungen (30) bestimmt wird.

## Revendications

1. Appareil de scellage (20) pour sceller des conditionnements (2) remplis d'un produit versable au sein d'une machine de conditionnement (1) ;
l'appareil de scellage (20) étant pourvu d'au moins une sonotrode (21) comprenant au moins :
- une tête (23) de sonotrode ; et
- une unité de commande de vibrations (25) connectée à la tête (23) de sonotrode et configurée pour engendrer des vibrations ultrasonores de la tête (23) de sonotrode ;
dans lequel l'unité de commande de vibrations (25) comprend :
- un ou plusieurs dispositifs transducteurs piézoélectriques (30) configurés pour générer des vibrations ultrasonores destinées à être injectées dans la tête (23) de sonotrode ; et
- un dispositif capteur (34) configuré pour mesurer, en cours d'utilisation, un ou plusieurs paramètres électriques dépendant du temps d'au moins un des un ou plusieurs dispositifs transducteurs piézoélectriques (30), le dispositif capteur (34) étant configuré pour déterminer des courbes dépendant du temps (33, 35, 36, 37) respectives des un ou plusieurs paramètres électriques des un ou plusieurs dispositifs transducteurs piézoélectriques (30),
l'appareil de scellage comprenant en outre une unité d'analyse (38) connectée fonctionnellement au dispositif capteur (34) et configurée pour recevoir et analyser les courbes dépendant du temps, l'unité d'analyse (38) étant configurée pour :
- déterminer un ou plusieurs paramètres caractéristiques à partir des une ou plusieurs courbes dépendant du temps (33, 35, 36, 37) ; et/ou
- déterminer un ou plusieurs paramètres caractéristiques à partir des une ou plusieurs courbes dépendant du temps (33, 35, 36, 37) et comparer les paramètres caractéristiques déterminés avec des paramètres de référence ; et/ou
- calculer, en fonction d'un ou de plusieurs paramètres caractéristiques des courbes dépendant du temps (33, 35, 36, 37), une capacité des empilements d'éléments piézoélectriques (31), une résistance équivalente, une inductance équivalente et une capacité équivalente d'un circuit électrique représentant la sonotrode ; et/ou
- comparer une ou plusieurs des courbes dépendant du temps (33, 35, 36, 37) avec des courbes de référence ; et/ou
- analyser des formes respectives des courbes dépendant du temps (33, 35, 36, 37) ; et/ou
- déterminer des informations sur le processus de scellage à partir des courbes dépendant du temps (33, 35, 36, 37).

2. Appareil de scellage selon la revendication 1, dans lequel les paramètres électriques sont choisis dans le groupe comprenant : un courant électrique, une tension électrique et/ou une puissance électrique.

3. Appareil de scellage selon l'une quelconque des revendications précédentes, comprenant en outre une unité d'analyse (38) connectée fonctionnellement au dispositif capteur (34) et configurée pour déterminer sélectivement un état de fonctionnement des un ou plusieurs dispositifs transducteurs piézoélectriques (30) en fonction des paramètres électriques respectifs déterminés par le dispositif capteur (34).

4. Appareil de scellage selon l'une quelconque des revendications précédentes, comprenant un dispositif capteur de température configuré pour déterminer une température des un ou plusieurs dispositifs transducteurs piézoélectriques (30).

5. Appareil de scellage selon la revendication 4, comprenant en outre une unité d'analyse (38) connectée fonctionnellement au dispositif capteur (34) et configurée pour déterminer sélectivement un état de fonctionnement des un ou plusieurs dispositifs transducteurs piézoélectriques (30) en fonction des paramètres électriques respectifs déterminés par le dispositif capteur (34) et de la température déterminée par le dispositif capteur de température.

6. Appareil de scellage selon l'une quelconque des revendications précédentes, dans lequel l'unité de commande de vibrations (25) comprend en outre au moins une coque formant logement (41) pourvue d'un espace intérieur (41) ;
dans lequel chaque dispositif transducteur piézoélectrique (30) et le dispositif capteur (34) sont agencés au sein de la coque formant logement (41).

7. Appareil de scellage selon l'une quelconque des revendications précédentes, dans lequel le dispositif capteur (34) comprend un ou plusieurs éléments capteurs (39) associés chacun à un seul dispositif transducteur piézoélectrique (30) respectif pour mesurer les un ou plusieurs paramètres électriques dépendant du temps du dispositif transducteur piézoélectrique (30) respectif, les un ou plusieurs éléments capteurs (39) comprenant de préférence un ou plusieurs capteurs à effet Hall et/ou capteurs shunt.

8. Machine de conditionnement (1) pour le conditionnement de produits versables dans des conditionnements (2), comprenant au moins un appareil de scellage (20) selon l'une quelconque des revendications 1 à 7.

9. Procédé pour faire fonctionner un appareil de scellage (20) selon l'une quelconque des revendications 1 à 7, le procédé comprenant au moins les étapes suivantes :
a) excitation de vibrations ultrasonores de la tête (23) de sonotrode par fonctionnement des un ou plusieurs dispositifs transducteurs piézoélectriques (30) ;
b) mesure d'un ou de plusieurs paramètres électriques dépendant du temps d'au moins un, de préférence chacun, des un ou plusieurs dispositifs transducteurs piézoélectriques (30),
d) analyse des paramètres électriques ; durant l'étape d), une unité d'analyse (38) de l'appareil de scellage (20) :
- déterminant un ou plusieurs paramètres caractéristiques à partir d'une ou de plusieurs courbes dépendant du temps des paramètres électriques ; et/ou
- déduisant un ou plusieurs paramètres caractéristiques à partir des une ou plusieurs courbes dépendant du temps et comparant les paramètres caractéristiques avec des paramètres de référence ; et/ou
- calculant, en fonction d'un ou de plusieurs paramètres caractéristiques des courbes dépendant du temps, une capacité des empilements d'éléments piézoélectriques (31), une résistance équivalente, une inductance équivalente et une capacité équivalente d'un circuit électrique représentant la sonotrode ; et/ou
- comparant une ou plusieurs des courbes dépendant du temps avec des courbes de référence ; et/ou
- analysant des formes respectives des courbes dépendant du temps ; et/ou
- déterminant des informations, de préférence des informations sur la qualité, concernant le processus de scellage exécuté par l'appareil de scellage (20) sur la base des un ou plusieurs paramètres électriques dépendant du temps ; et/ou
- déterminant un état de fonctionnement des un ou plusieurs dispositifs transducteurs piézoélectriques sur la base des un ou plusieurs paramètres électriques dépendant du temps.

10. Procédé selon la revendication 9, dans lequel, durant l'étape c), la durée de vie restante et/ou le vieillissement et/ou l'état de santé et/ou un état de fonctionnement anormal des un ou plusieurs dispositifs transducteurs piézoélectriques (30) sont déterminés.
